**Europäisches Patentamt**

**European Patent Office**

**Office européen des brevets**

(19)

(11) Numéro de publication : **0 298 846 B1**

# (12) FASCICULE DE BREVET EUROPEEN

(45) Date de publication du fascicule du brevet :
**11.03.92 Bulletin 92/11**

(51) Int. Cl.⁵ : **H03K 3/03**, H03B 5/32

(21) Numéro de dépôt : **88401711.2**

(22) Date de dépôt : **01.07.88**

(54) **Oscillateur à résonateur piézo-électrique.**

(30) Priorité : **07.07.87 FR 8709623**

(43) Date de publication de la demande :
**11.01.89 Bulletin 89/02**

(45) Mention de la délivrance du brevet :
**11.03.92 Bulletin 92/11**

(84) Etats contractants désignés :
**DE FR GB IT NL**

(56) Documents cités :
**DE-A- 2 245 476**
**DE-A- 3 124 492**
**GB-A- 1 366 858**
**US-A- 3 699 476**

(56) Documents cités :
**ELECTRONICS COMPONENTS & APPLICA-**
**TIONS, vol. 7, no. 2, 1985, pages 73-76, Eindho-**
**ven, NL; J. EXALTO:** "Crystal oscillators using
**HCMOS ICs**"
**PATENT ABSTRACTS OF JAPAN, vol. 9, no. 47**
**(E-299)[1770], 27 février 1985, page 131 E 299;**
**& JP-A-59 188 203**
"Modern Electronic Circuits Reference
**Manual**", John Markus, 1980, page 688
**R.J. Matthys,** "Crystal Oscillator Circuits", J.
**Wiley and Sons, 1983, pages 61-63, 195,196**

(73) Titulaire : **THOMSON-CSF**
**51, Esplanade du Général de Gaulle**
**F-92800 Puteaux (FR)**

(72) Inventeur : **Quievy, Didier**
**THOMSON - CSF SCPI - 19, avenue de**
**Messine**
**F-75008 Paris (FR)**

(74) Mandataire : **Benoit, Monique et al**
**THOMSON-CSF SCPI**
**F-92045 PARIS LA DEFENSE CEDEX 67 (FR)**

**Description**

La présente invention a principalement pour objet un oscillateur à résonateur piézo-électrique.

L'utilisation d'oscillateurs à résonateur piézoélectrique à quartz se généralise aussi bien dans les équipements grand public que professionnels. La plupart des oscillateurs à résonateur piézo-électrique de types connus comportent un composant analogique type amplificateur linéaire équipé d'un résonateur piézo-électrique disposé dans une boucle d'entretien des oscillations.

Certains cependant utilisent des circuits logiques. L'article intitulé "Cristal oscillators using HCMOS ICs " paru dans la revue Electronics Component et applications, vol. 7, N° 2, 1985 pages 73-76, décrit par exemple un oscillateur à quartz de type Pierce utilisant un inverseur logique HCMOS et présentant une boucle d'entretien des oscillations comportant une résistance ou une capacité connectée entre la sortie de l'inverseur logique et le quartz dont les deux bornes de connexion sont couplées à la masse par des capacités. Le brevet américain US-A-3,699,476 donne un autre exemple d'oscillateur à quartz de type Pierce utilisant un inverseur logique et présentant une boucle d'entretien des oscillations à quartz shuntée par la connexion série d'une résistance et d'une inductance. Malgré leur simplicité, ces montages n'ont pas connu de développements importants en raison de leurs performances médiocres notamment en ce qui concerne la stabilité à court terme.

On connait également, par le livre de R.J. Matthys intitulé : "Crystal Oscillator Circuits" et paru aux éditions J. Wiley and Sons, 1983, aux pages 195 et 196 un oscillateur piézo-électrique utilisant un circuit logique ECL du type amplificateur différentiel pour récepteur de ligne et présentant dans sa boucle d'entretien des oscillations un circuit passif qui élève la tension engendrée par le résonateur piézo-électrique pour l'appliquer à l'entrée de l'amplificateur différentiel et qui est constitué d'une prise capacitive montée sur un circuit oscillant parallèle.

La présente invention permet la réalisation d'oscillateurs à l'aide d'au moins un circuit logique équipé d'une boucle d'entretien d'oscillations à résonateur piézo-électrique qui ont d'excellentes performances avec, entre autre, une excellente stabilité à court terme. Ainsi, on obtient un oscillateur dont les performances sont au moins comparables à celles d'un oscillateur utilisant un circuit analogique, avec la simplicité de construction et la modicité du coût dues à l'utilisation des circuits logiques.

L'oscillateur selon la présente invention comporte un circuit logique avec une sortie et au moins une entrée, équipé d'une boucle d'entretien des oscillations qui relie ladite sortie à ladite entrée du circuit logique et comporte mis en série, un résonateur piézo-électrique et un circuit passif élévateur de tension constitué soit d'un transformateur soit d'un circuit en ¶ avec inductance série et capacités parallèles au capacité série et inductances parallèles, le résonateur piézo- électrique étant connecté à la sortie du circuit logique. Ainsi, on utilise toute la dynamique d'entrée du circuit logique et on diminue l'impédance de charge du résonateur piézo-électrique.

La stabilité à court terme concerne les fluctuations à court terme du signal issu de l'oscillateur. Un oscillateur idéal accordé à la fréquence de résonance $f_o$, délivre un pic de Dirac à la fréquence $f_o$ et aucune énergie à d'autres fréquences. Malheureusement, dans la pratique, un oscillateur engendre aussi de l'énergie autour de la fréquence $f_o$.

L'oscillateur selon la présente invention permet de réduire la contribution à court terme de l'énergie engendrée par l'oscillateur autour de la fréquence $f_o$, pour un faible coût et de façon aisément reproductible.

L'invention sera mieux comprise a moyen de la description ci-après et des figures annexées données comme des exemples non limitatifs parmi lesquels :

– la figure 1 est un schéma d'un oscillateur de type connu ;

– la figure 2 est un schéma de principe de l'oscillateur selon la présente invention ;

– la figure 3 est un schéma d'un premier exemple de réalisation de l'oscillateur selon la présente invention ;

– la figure 4 est un schéma d'un deuxième exemple de réalisation de l'oscillateur selon la présente invention ;

– la figure 5 est un troisième exemple de réalisation de l'oscillateur selon la présente invention.

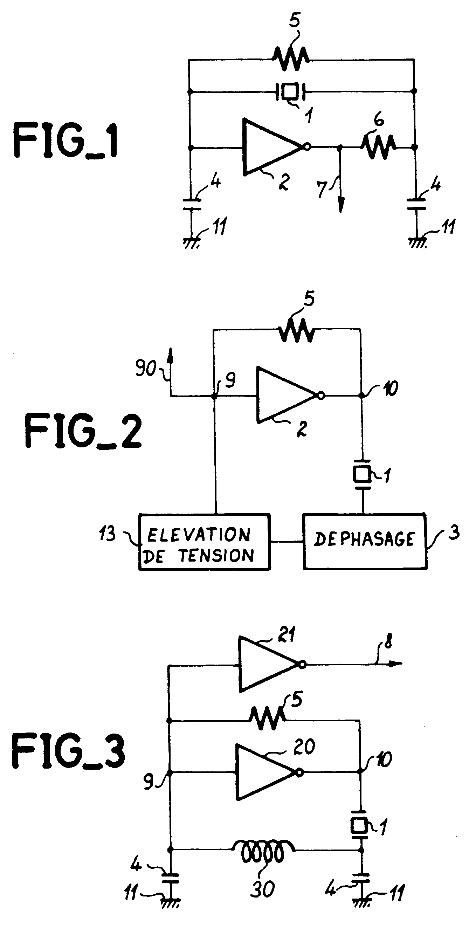

Sur les figures 1 à 5 on a utilisé les mêmes références pour désigner les mêmes éléments.

Sur la figure 1, on peut voir un prototype d'oscillateur à résonateur à quartz de type connu, l'oscillateur comporte un résonateur à quartz 1 connecté dans une boucle comportant d'autre part un inverseur 2 et une résistance 6. Aux bornes de l'inverseur 2 et de la résistance 6 mise en série est placée une résistance de polarisation 5. Les bornes du résonateur 1 sont reliées par deux condensateurs 4 à la masse 11. Le signal est recueilli à la sortie de la porte logique inverseuse 2 sur une sortie 7.

L'inverseur 2 crée un déphasage de 180° entre les signaux d'entrée et de sortie. A ce déphasage s'ajoute un déphasage, croissant avec la fréquence d'oscillation, dû au temps de propagation. La résistance 6, le résonateur 1 ainsi que le condensateur 4 fournissent un déphasage supplémentaire nécessaire à l'obtention d'oscillation. La résistance 5 polarise la porte logique 2 autour d'un point de fonctionnement situé à la moitié de la tension d'alimentation. Ainsi, il est possible d'utiliser la porte logique 2 en faibles signaux en tant qu'amplificateur linéaire.

Le dispositif de la figure 1 présente toutefois une faible stabilité à court terme. Cela est dû notamment au fait que la dynamique d'entrée de la porte 2 n'est pas entièrement exploitée car la présence de la résistance 6 et des condensateurs 4 affaiblit le signal délivré par la porte entraînant une dégradation du rapport signal à bruit.

De plus, l'impédance de charge du quartz est relativement élevée. L'impédance de charge du quartz élevée ne permettant pas l'utilisation du meilleur coefficient de surtension en charge du quartz. Ceci entraîne une dégradation supplémentaire du rapport signal/bruit pour les fréquences de modulation inférieures à $f_o/2 \times Q$, ou $Q$ est le coefficient de surtension du résonateur en charge. Ainsi, l'oscillateur illustré sur la figure 1 présente des performances nettement inférieures à celles de l'oscillateur comportant un amplificateur analogique de type connu.

Sur la figure 2, on peut voir un schéma de principe de l'oscillateur à résonateur piézo-électrique.

L'oscillateur comporte une porte logique 2, par exemple un inverseur. La porte logique comprend une entrée 9 et une sortie 10. A la sortie 10 la porte logique 2 est connectée à un résonateur 1. Le résonateur 1 est par exemple un cristal de quartz ou de niobate de lithium. Le résonateur engendre soit des ondes de volumes soit des ondes acoustiques de surface.

Avantageusement, le résonateur 1 est un cristal de quartz en coupe AT. La sortie du résonateur 1 est connectée à un dispositif de déphasage 3. Le dispositif de déphasage 3 induit un retard dans la propagation du signal. La sortie du dispositif de déphasage 3 est connectée à un dispositif d'élévation de tension 13.

Avantageusement, le dispositif d'élévation de tension 13 est un dispositif passif comportant par exemple des selfs et des condensateurs ou un transformateur.

L'ordre du dispositif de déphasage 3 et des moyens d'élévation de tension 13 peut être inversé sans sortir du cadre de la présente invention. De même les moyens d'élévation de tension 13 et le dispositif de déphasage 3 peuvent être regroupés à un seul dispositif.

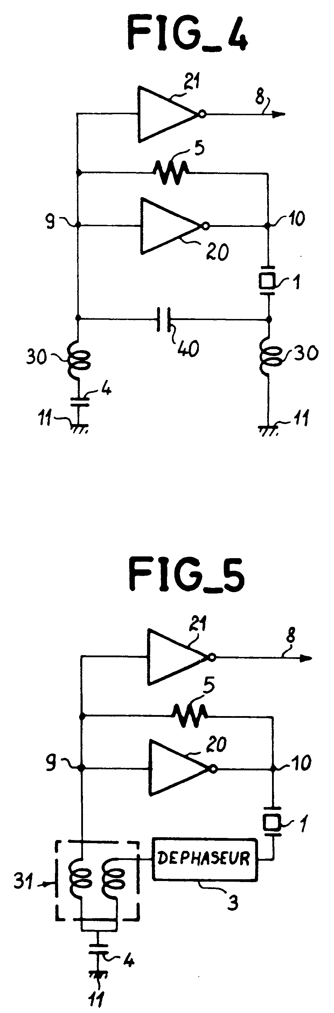

Le dispositif de déphasage induit un retard nécessaire au fonctionnement de l'oscillateur selon la présente invention. Le retard diminue si l'on monte en fréquence. Ainsi pour un travail en haute fréquence il peut s'avérer que le dispositif de déphasage 3 n'est pas nécessaire. Un tel exemple de réalisation est illustré sur la figure 4.

La sortie des moyens d'élévation de tension est connectée à l'entrée 9 de la porte logique 2.

L'entrée 9 de la porte logique 2 est reliée à la sortie 10 de ladite porte par l'intermédiaire d'une résistance de polarisation 5.

Dans l'exemple de réalisation non illustré on utilise pour la polarisation de la porte logique 2 une résistance mise en série avec une self inductance.

Avantageusement, le dispositif de déphasage 3 est un dispositif de déphasage réactif. Ainsi il n'induit aucun bruit, contrairement à la résistance 6 de la figure 1.

La résistance, ou la résistance et une inductance (non représentée) 5 polarise et contre-réactionne en continu la porte logique 2. La porte logique étant un inverseur les valeurs moyennes des tensions d'entrée au point 9 et de sortie au point 10 sont ainsi identiques.

Le résonateur 1 est directement attaqué par le signal de sortie de la porte logique 2. Ceci permet une meilleure utilisation de la dynamique de la porte logique 2. L'utilisation des moyens d'élévation de tension 13 permet d'élever la tension à l'entrée de la porte logique 2 et d'adapter les impédances. Ainsi l'impédance présentée au résonateur 1 peut être relativement basse d'où un meilleur coefficient de surtension en charge. De plus la dynamique d'entrée de la porte logique 2 est entièrement exploitée.

Dans une première variante de réalisation la sortie du dispositif fournissant la fréquence de référence désirée est connectée à la sortie 10 de la porte logique 2.

Avantageusement, la sortie 90 du dispositif est connectée à l'entrée 9 de la porte logique 2. Dans ce cas, on obtient un meilleur rapport signal/bruit surtout au-delà des fréquences de modulation $f_o/2\ Q$.

Avantageusement, la porte logique 2 est réalisée en techonogie CMOS ou HCMOS.

Les spectres de l'oscillateur selon la présente invention peuvent être décrits par le modèle de Leeson. Le modèle de Leeson est notamment décrit dans D.B. Leeson "Simple model of feedback oscillator noise spectrum" Proceding IEEE - page 329 - February 1966 et G. Sauvage "Phase noise in oscillators : A Mathematical analysis of Leeson's Model" IEEE Transation on Instrumentation and Measurement page 408 -December 1977.

Sur la figure 3, on peut voir un exemple de réalisation d'un oscillateur selon la présente invention. Le dispositif de la figure 3 comporte une première porte inverseuse 20 dont la sortie 10 est connectée à un résonateur 1. La sortie du résonateur est reliée d'une part à travers un condensateur 4 à la masse 11, et d'autre part à travers une self inductance 30 à l'entrée 9 de ladite porte logique inverseuse 20. L'entrée 9 de la porte logique inverseuse 20 est reliée à la masse 11 à travers un condensateur 4. L'entrée 9 de la porte logique inverseuse 20 est reliée à la sortie 10 de la porte logique inverseuse 20 à travers une résistance de polarisation 5.

La self inductance 30 associée au condensateur 4 joue le rôle d'un moyen d'élévation de tension 13 et du dispositif de déphasage 3. La porte logique inverseuse est par exemple réalisée en technologie HCMOS non bufferisée du type HCU04. Par exemple, on utilise le circuit HCU04 vendu par la société Motorola comportant six inverseurs élémentaires dans un même boîtier.

Avantageusement, la sortie 8 du dispositif selon la présente invention est connectée à la sortie d'une porte logique 21. Ainsi, on assure l'isolation et une amplification en courant de la sortie. La porte 21 reliée à la sortie 8 est par exemple une porte logique inverseuse.

Avantageusement, l'entrée de ladite porte logique inverseuse 21 est reliée au point 9.

Avantageusement, on utilise une seconde porte logique inverseuse appartenant au même boîtier pour assurer l'amplification et l'isolation de sortie. Ainsi, le bon fonctionnement de la porte logique 21 est assuré par la polarisation de la porte logique 20.

Dans l'exemple de réalisation illustré sur la figure 3 on a utilisé un résonateur à quartz en coupe AT fonctionnant en mode fondamental ou en mode partiel (harmonique), ce dispositif fonctionne parfaitement de fréquences basses jusqu'en hautes fréquences (H.F.). Les limites de fonctionnement pour cet exemple correspondant à environ 100 MHz induites par le temps de propagation de la porte 20.

Dans le dispositif de la figure 3 le bruit minimal a été inférieur à - 175 dBc/Hz, pour des fréquences de modulation FM supérieures à 100 kHz. Le bruit à 1 kHz de la porteuse est de l'ordre de - 162 dBc/Hz.

L'oscillateur selon la présente invention n'est pas limité à des circuits ou des portes logiques particulières. L'adaptation de l'oscillateur dans le fonctionnement de fréquences plus élevées est à la portée de l'homme de l'art. Par exemple pour des fréquences de l'ordre de 200 MHz on utilise un transformateur d'impédance de type passe-bande ce qui permet de ne pas introduire de déphasage supplémentaire, qui n'est plus nécessaire dans un tel cas.

Sur la figure 4, on peut voir un oscillateur selon la présente invention concernant comme moyen d'élévation de tension un filtre passe-haut. Un tel filtre peut, selon les valeurs des composants utilisés induire une avance de phase permettant le travail de l'oscillateur à très haute fréquence en compensant les retards de phase induits dans la boucle du résonateur 1.

La sortie du résonateur 1 est reliée à l'entrée 9 de la porte logique 20 par un condensateur 40 et à la masse 11 par une self inductance 30. Dans ce cas, le blocage du courant continu est assuré par le résonateur 1.

Dans une variante de réalisation, la self inductance 30 est reliée à la masse 11 par un condensateur 4.

L'entrée 9 de la porte logique 20 est reliée à la masse 11 à travers une self inductance 30 et un condensateur 4.

Les condensateurs 4 sont des condensateurs de couplage destinés à empêcher le passage du courant continu.

Sur la figure 5, on peut voir une variante de réalisation dans laquelle la boucle comportant la porte logique 20 et le résonateur 1 est refermée par un transformateur 31.

Le transformateur 31 comporte un bobinage primaire la sortie du résonateur 1 reliant à la masse 11 à travers un condensateur 4.

Le transformateur 31 comporte un bobinage secondaire reliant l'entrée 9 de la porte logique 20 à la masse 11 à travers un condensateur 4. Les bobinages primaires et secondaires sont couplés par mutuelle inductance.

Pour des fréquences de fonctionnement élevées la sortie du résonateur 1 est directement reliée à l'entrée du transformateur 31.

Dans une variante de réalisation du dispositif selon la présente invention les points froids des bobinages du transformateur 31 sont reliés à une première armature d'un condensateur 4. La seconde armature du condensateur 4 est reliée à la masse 11.

Pour des fréquences de fonctionnement plus basses la sortie du résonateur 1 est reliée à l'entrée du transformateur 31 à travers un dispositif de déphasage 3.

Le transformateur 31 joue le rôle d'un filtre passe-bande n'induisant pas de retard d'avance de phase dans le signal.

L'invention s'applique principalement à la réalisation d'oscillateurs de grande stabilité, notamment à court terme et des dispositifs utilisant de tels oscillateurs. On peut citer à titre d'exemples les radars, les émetteurs, les récepteurs, les dispositifs de synchronisation, les dispositifs de pilotage des moteurs, la réalisation de base de temps ou la réalisation des calculateurs.

**Revendications**

1. Oscillateur comportant un circuit logique (20), avec une sortie (10) et au moins une entrée (9), équipé d'une boucle d'entretien des oscillations à résonateur piézo-électrique (1) reliant la sortie (10) à ladite entrée (9) et de moyens de polarisation de ladite entrée (9) du circuit logique (20) constitués d'une résistance et/ou self inductance (5) reliant la sortie (10) à ladite entrée (9), caractérisé en ce que la boucle d'entretien des oscillations comporte un circuit passif qui élève la tension du signal appliqué par le résonateur piézo-électrique (1) à ladite entrée (9) de circuit logique (20) et qui comporte une inductance (30) intercalée en série entre le résonateur piézo-électrique (1) et ladite entrée (9) du circuit logique (20), et des condensateurs (4) connectés entre les extrémités de l'inductance (30) et la terre.

2. Oscillateur comportant un circuit logique (20),

avec une sortie (10) et au moins une entrée (9), équipé d'une boucle d'entretien des oscillations à résonateur piézo-électrique (1) reliant la sortie (10) à ladite entrée (9) et de moyens de polarisation de ladite entrée (9) du circuit logique ( 20) constitués d'une résistance et/ou self inductance (5) reliant la sortie (10) à ladite entrée (9), caractérisé en ce que la boucle d'entretien des oscillations comporte un circuit passif qui élève la tension du signal appliqué par le résonateur piézo-électrique (1) à ladite entrée (9) du circuit logique (20) et qui comporte un condensateur (40) intercalé en série entre le résonateur piézo-électrique (1) et ladite entrée (9) du circuit logique (20), et des inductances (30) connectées entre les extrémités du condensateur (40) et la terre, l'inductance (30) disposée du côté de ladite entrée (9) du circuit logique (20) étant reliée à la terre par un condensateur d'isolement (4).

3. Oscillateur comportant un circuit logique (20) avec une sortie (10) et au moins une entrée (9), équipé d'une boucle d'entretien des oscillations à résonateur piézo-électrique (1) reliant la sortie (10) à ladite entrée (9) et de moyens de polarisation de ladite entrée (9) du circuit logique (20) constitués d'une résistance et/ou self inductance (5) reliant la sortie (10) à ladite entrée (9), caractérisé en ce que la boucle d'entretien des oscillations comporte un transformateur (31) qui élève la tension du signal appliqué par le résonateur piézo-électrique (1) à ladite entrée (9) du circuit logique (20).

4. Oscillateur selon la revendication 3, caractérisé par le fait que la boucle d'entretien des oscillations comporte en outre un dispositif déphaseur (3).

5. Oscillateur selon l'une des revendications 1 à 4, caractérisé en ce que le circuit logique (20) est un inverseur.

6. Oscillateur selon l'une des revendications 1 à 5, caractérisé par le fait que le circuit logique est réalisé en technologie CMOS.

7. Oscillateur selon l'une des revendications 1 à 5, caractérisé par le fait que le circuit logique est réalisé en technologie HCMOS.

8. Oscillateur selon l'une des revendications 1 à 5, caractérisé par le fait que la sortie (90) dudit oscillateur est connectée à l'entrée (9) dudit circuit logique.

**Patentansprüche**

1. Oszillator mit einem logischen Kreis (20), der einen Ausgang (10) und mindestens einen Eingang (9) aufweist, wobei der Oszillator eine Schwingkreisschleife mit einem piezoelektrischen Resonator (1) besitzt, die den Ausgang (10) mit dem Eingang (9) verbindet, und mit Vorspannungsmitteln für den Eingang (9) des logischen Kreises (20), die aus einem Widerstand (5) und/oder einer Induktivität bestehen und den Ausgang (10) mit dem Eingang (9) verbinden, dadurch gekennzeichnet, daß die Schwingkreisschleife einen passiven Kreis aufweist, der die Spannung des vom piezoelektrischen Resonator (1) an den Eingang (9) des logischen Kreises (20) angelegten Signals erhöht und eine Induktivität (30), die in Reihe zwischen den piezoelektrischen Resonator (1) und den Eingang (9) des logischen Kreises (20) eingefügt ist, und Kondensatoren (4) aufweist, die zwischen den Enden der Induktivität (30) und Erde angeschlossen sind.

2. Oszillator mit einem logischen Kreis (20), der einen Ausgang (10) und mindestens einen Eingang (9) aufweist, wobei der Oszillator eine Schwingkreisschleife mit einem piezoelektrischen Resonator (1) besitzt, die den Ausgang (10) mit dem Eingang (9) verbindet, und mit Vorspannungsmitteln für den Eingang (9) des logischen Kreises (20), die aus einem Widerstand (5) und/oder einer Induktivität bestehen und den Ausgang (10) mit dem Eingang (9) verbinden, dadurch gekennzeichnet, daß die Schwingkreisschleife einen passiven Kreis aufweist, der die Spannung des vom piezoelektrischen Resonator (1) an den Eingang (9) des logischen Kreises (20) angelegten Signals erhöht und der einen Kondensator (40), der in Reihe zwischen den piezoelektrischen Resonator (1) und den Eingang (9) des logischen Kreises (20) eingefügt ist, und Induktivitäten (30) aufweist, die zwischen den Enden des Kondensators (40) und Erde angeschlossen sind, wobei die Induktivität (30), die sich auf der Seite des Eingangs (9) des logischen Kreises (20) befindet, über einen Isolationskondensator (4) mit Erde verbunden ist.

3. Oszillator mit einem logischen Kreis (20), der einen Ausgang (10) und mindestens einen Eingang (9) aufweist, wobei der Oszillator eine Schwingkreisschleife mit einem piezoelektrischen Resonator (1) besitzt, die den Ausgang (10) mit dem Eingang (9) verbindet, und mit Vorspannungsmitteln für den Eingang (9) des logischen Kreises (20), die aus einem Widerstand (5) und/oder einer Induktivität bestehen und den Ausgang (10) mit dem Eingang (9) verbinden, dadurch gekennzeichnet, daß die Schwingkreisschleife einen Transformator (31) enthält, der die Spannung des vom piezoelektrischen Resonator (1) an den Eingang (9) des logischen Kreises (20) angelegten Signals erhöht.

4. Oszillator nach Anspruch 3, dadurch gekennzeichnet, daß die Schwingkreisschleife außerdem einen Phasenschieber (3) enthält.

5. Oszillator nach einem der Ansprüche 1 bis 4, dadurch gekennzeichnet, daß der logische Kreis (20) ein Inverter ist.

6. Oszillator nach einem der Ansprüche 1 bis 5, dadurch gekennzeichnet, daß der logische Kreis in CMOS-Technologie ausgeführt ist.

7. Oszillator nach einem der Ansprüche 1 bis 5, dadurch gekennzeichnet, daß der logische Kreis in HCMOS-Technologie ausgeführt ist.

8. Oszillator nach einem der Ansprüche 1 bis 5, dadurch gekennzeichnet, daß der Ausgang (90) des Oszillators an den Eingang (9) des logischen Kreises angeschlossen ist.

**Claims**

1. An oscillator comprising a logic circuit (20) having an output (10) and at least one input (9) and supplied with an oscillation-maintaining loop which includes a piezoelectric resonator (1) and connects the output (10) to the input (9), and comprising biasing means for said input (9) of the logic circuit (20), these means being constituted by a resistor (5) and/or a self connecting the output (10) to said input (9), characterized in that the'oscillation-maintaining loop comprises a passive circuit which elevates the voltage of the signal applied by the piezoelectric resonator (1) to said input (9) of the logic circuit (20) and which comprises an inductance (30) inserted in series between the piezoelectric resonator (1) and said input (9) of the logic circuit (20), and capacitors (4) connected between the terminals of the inductance (30) and ground.

2. An oscillator comprising a logic circuit (20) having an output (10) and at least one input (9) and supplied with an oscillation-maintaining loop which includes a piezoelectric resonator (1) and connects the output (10) to the input (9), and comprising biasing means for said input (9) of the logic circuit (20), these means being constituted by a resistor (5) and/or a self connecting the output (10) to said input (9), characterized in that the oscillation-maintaining loop comprises a passive circuit which elevates the voltage of the signal applied by the piezoelectric resonator (1) to said input (9) of the logic circuit (20) and which comprises a capacitor (40) connected in series between the piezoelectric resonator (1) and said input (9) of the logic circuit (20), and inductances (30) connected between the terminals of the capacitor (40) and ground, the inductance (30) disposed at the side of the input (9) of the logic circuit (20) being connected to ground via an insulating capacitor (4).

3. An oscillator comprising a logic circuit (20) having an output (10) and at least one input (9) and supplied with an oscillation-maintaining loop which includes a piezoelectric resonator (1) and connects the output (10) to the input (9), and comprising biasing means for said input (9) of the logic circuit (20), these means being constituted by a resistor (5) and/or a self connecting the output (10) to said input (9), characterized in that the oscillation-maintaining loop comprises a transformer (31) which elevates the voltage of the signal applied by the piezoelectric resonator (1) to said input (9) of the logic circuit (20).

4. An oscillator according to claim 3, characterized in that the oscillation-maintaining loop further comprises a phase-shifting device (3).

5. An oscillator according to one of claims 1 to 4, characterized in that the logic circuit (20) is an inverter.

6. An oscillator according to one of claims 1 to 5, characterized in that the logic circuit is made according to CMOS technology.

7. An oscillator according to one of claims 1 to 5, characterized in that the logic circuit is made according to HCMOS technology.

8. An oscillator according to one of claims 1 to 5, characterized in that the output (90) of said oscillator is connected to the input (9) of said logic circuit.

FIG_1

FIG_2

ELEVATION
DE TENSION

DEPHASAGE

FIG_3

# FIG_4

# FIG_5